# EUROPEAN PATENT APPLICATION

(11) **EP 1 767 307 A1**
(43) Date of publication of application: **28.03.2007**
(21) Application number: 05753406.7
(22) Date of filing: 21.06.2005
(51) Int. Cl.: B23K 9/32, B23K 9/073, H02M 9/00, H05K 7/20

(54) **ARC WELDING CONTROL DEVICE**

(30) Priority: 24.06.2004 JP 2004186083
(71) Applicant: MATSUSHITA ELECTRIC INDUSTRIAL CO., LTD., Osaka 571-8501 (JP)
(72) Inventor: OYAMA, Hidetoshi, . (JP); TABATA, Yoshiyuki, . (JP); MUTO, Yasumichi, . (JP); MUKAI, Yasushi, . (JP)
(74) Representative: Grünecker, Kinkeldey, Stockmair & Schwanhäusser Anwaltssozietät
(86) International application number: PCT/JP2005/011350
(87) International publication number: WO 2006/001273

(57) **Abstract**

In the conventional arc welding control unit, since the air of the outside of the equipment is applied directly to the whole of the main semiconductor for cooling, there is found a problem that dust, welding fumes and the like can accumulate on or adhere to the conductive portions of the inside of the equipment, which takes time for maintenance of the equipment. To solve this, according to the invention, there is provided an arc welding control unit having a heat radiating unit built in the box body thereof for discharging the air heated by a heat generating first electrical element to the outside. The heat radiating unit has a tunnel-type shape including an outer peripheral portion for defining a cavity portion allowing the air to flow therethrough, whereby dust, welding fumes and the like can be prevented from accumulating on or adhering to the conductive portions of the inside of the equipment.

## Description

### FIELD OF THE INVENTION

The invention relates to a cooling structure provided in an arc welding control unit.

### BACKGROUND TECHNOLOGY

Recently, the rate of operation of industrial equipment has increased greatly. In these circumstances, an emphasis has been put on the facility of the maintenance of an arc welding control unit.

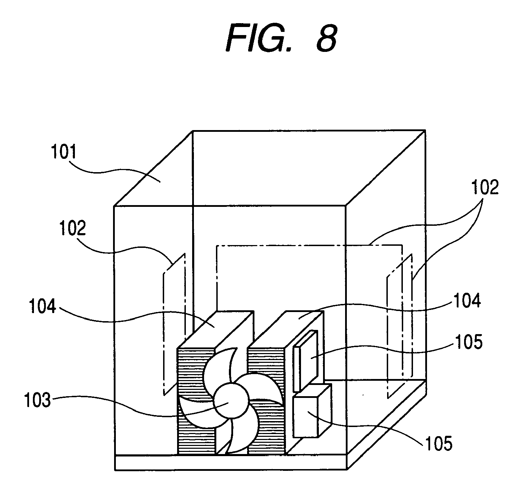

Fig. 8 is a perspective view of the structure of a conventional arc welding control unit, in particular, a perspective view of a box body part arranged on the outer side of the control unit. In Fig. 8, reference character 101 designates a box body provided in the arc welding control unit, 102 an air intake/exhaust opening, 103 a fan, 104 a heat sink, and 105 a main semiconductor, respectively. By the way, in fact, there are provided various components and wires which are used to enforce arc welding; however, they are not connected directly with the description of the invention and thus the description thereof is omitted here. Also, the description of the circuit configurations of the control unit is also omitted here for the same reason.

In the above-structured conventional arc welding control unit, as a method for cooling the main semiconductor (for example, a switching element such as a power transistor) which gives off intense heat, there is employed a method in which the heat sink is intensively cooled and the air is applied to the whole of the main semiconductor to thereby cool the main semiconductor: that is, the control unit is structured such that the air existing in the outside of the control unit is taken into or discharged from the whole of the inside of the control unit for cooling.

Specifically, as shown in Fig. 8, the fan 103 is operated to take in the air from the outside and the air is applied to an integrated body formed by contacting the heat sink 104 with the main semiconductor 5, while the air heated is exhausted from the air intake/exhaust opening 102 to thereby discharge the heat of the control unit.

By the way, an embodiment showing the above technology is disclosed, for example, in the patent literature 1. That is, the patent literature 1 teaches a cooling structure for an arc welding machine or the like, in which a heat radiating fin is attached to a power semiconductor module giving off intense heat and the power semiconductor module is cooled using the air. Patent literature 1: JP Hei-8-214549 publication (Fig. 1)

### DISCLOSURE OF THE INVENTION

### PROBLEMS TO BE SOLVED BY THE INVENTION

However, in the conventional arc welding control unit, since the air of the outside of the equipment is applied to the whole of the main semiconductor to thereby cool it, there is found a problem that dust, welding fumes and the like can accumulate on and adhere to the conductive portions of the inside of the equipment, which takes time for maintenance of the equipment.

It is an object of the invention to provide an arc welding control unit which not only can improve the maintenance of the equipment greatly but also can secure the reliability of the equipment.

### MEANS FOR SOLVING THE PROBLEMS

In solving the above problems, according to the invention, there is provided an arc welding control unit having a heat radiating unit built in the box body thereof for discharging the air heated by a heat generating first electrical element to the outside, in which the heat radiating unit has a tunnel-type shape including an outer peripheral portion for defining a cavity portion allowing the air to pass therethrough.
Also, the heat radiating unit used in the arc welding control unit of the invention has a substantially cuboid shape including a side surface portion and a top surface portion for defining the cavity portion, and the two side end portions of the cavity portion are formed as openings through which the air is allowed to pass through. Further, the openings of the two side end portions of the heat radiating unit are disposed to face the inside surface of the box body, and the heat generating first electrical element is used in at least part of the outer peripheral portion defining the cavity portion.

And, the heat generating electrical element used in the arc welding control unit of the invention includes a heat sink having a heat radiating fin, the heat radiating fin is disposed so as to be exposed to the inside of the cavity portion through which the air is allowed to pass, and, on one of the two heat radiating unit openings, there is provided a fan for forcing the air within the cavity portion to flow. Also, the heat radiating unit has two or more rows of cavity portions, while each of the two or more rows of cavity has a fan.

### EFFECTS OF THE INVENTION

As has been described above, according to the invention, provision of the box body for cooling can prevent dust, welding fumes and the like from accumulating on or adhering to the conductive portions of the inside of the equipment, which can greatly improve the maintenance of the equipment as well as can secure the reliability of the equipment.

### BEST MODE FOR CARRYING OUT THE INVENTION

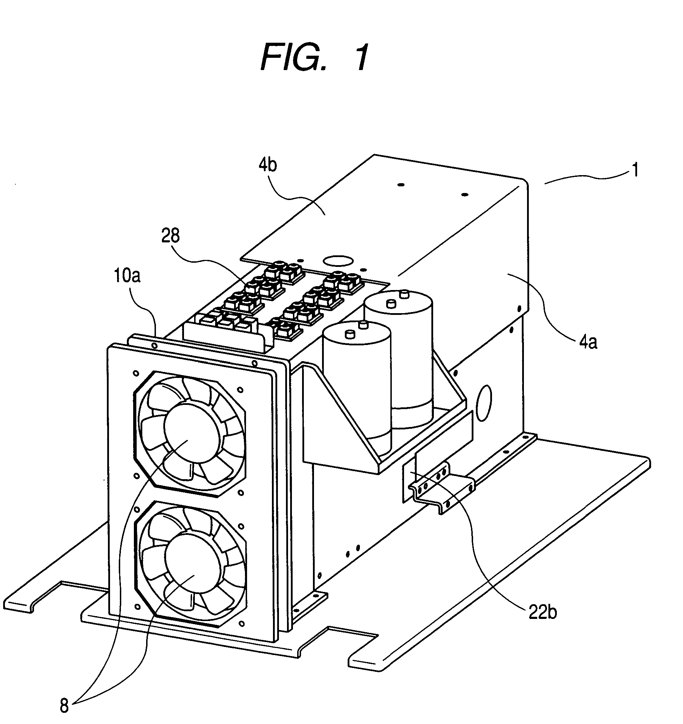

Now, description will be given below of the best mode for enforcing the invention with reference to Figs. 1 to 7.

### (Embodiment 1)

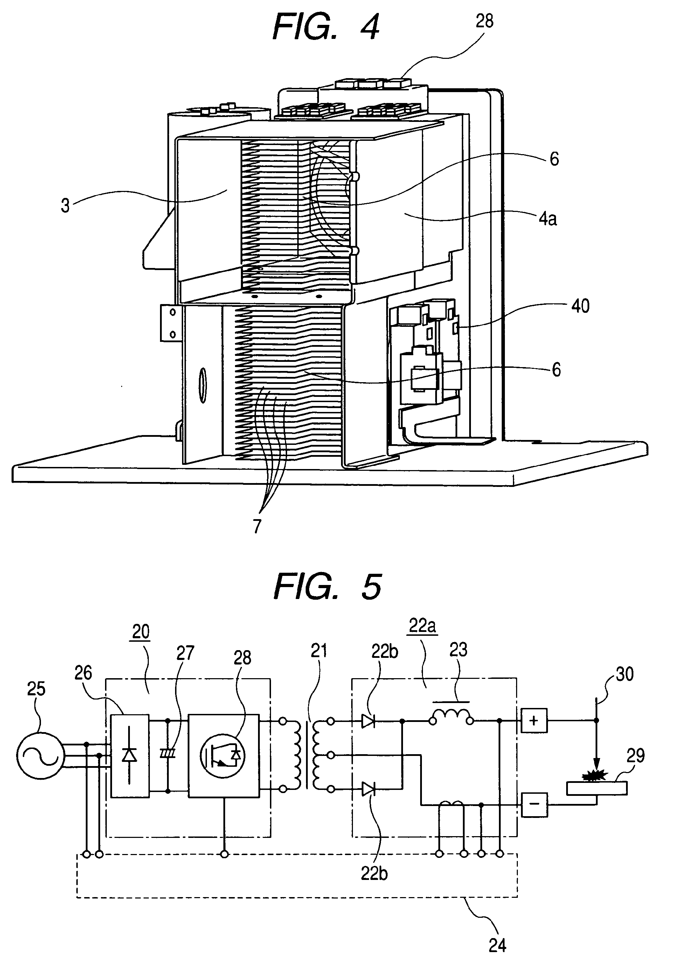

Firstly, with reference to Fig. 5, description will be given below in brief of the circuit configurations of an arc welding control unit according to the present embodiment of the invention. Fig. 5 is a circuit diagram of the circuit configurations of the arc welding control unit according to the present embodiment. In Fig. 5, a portion thereof shown by a one-dot chained line and given reference character 20 is a primary side inverter circuit, 28 designates a power transistor used as an inverter (switching means) in the primary side inverter circuit 20, 21 stands for a main transformer, a portion shown by a two-dot chained line and given reference character 22 is a secondary side main circuit, 23 designates a dc reactor, and 24 stands for a control circuit.

Now, description will be given below in brief of the operation of the present embodiment with reference to the above circuit configurations. Power supplied from a commercial power supply 25 is rectified by a primary rectify diode 26 in the primary side inverter circuit 20, and the thus rectified power is smoothed and converted to a direct current by a primary smoothing capacitor 27. And, the voltage and current are inverter controlled by the power transistor 28 so as to provide the voltage and current of a desired high frequency. Further, the voltage is raised from the primary side to the secondary side by the main transformer 21, the current is converted again to a direct current by a secondary side rectify diode, positive and negative voltages are respectively output, and arcs are discharged between a wire 30 and a base metal 29 for enforcing arc welding. By the way, the dc reactor 23 in the secondary side circuit cuts high frequency components to improve the quality of the arc welding. Also, the control circuit 24 is used to control the output voltage and current in the primary side inverter circuit 20 and in the secondary side circuit in order to stabilize the quality of the arc welding.

Next, description will be given below of a heat radiating unit used in the arc welding control unit according to the present embodiment with reference to Fig. 1. A heat radiating unit 1 carries thereon the primary side inverter circuit 20, secondary side main circuit 22 and the like previously described with reference to Fig. 5, and is disposed in the form of a unit in the arc welding control unit. The heat radiating unit 1 has a heat radiating mechanism in order to cool the power transistor 28 and the like which give off intense heat.

Fig. 1 is a perspective view of a heat radiating unit used in an arc welding control unit according to the present embodiment, when viewed from the backward and rightward direction of the heat radiating unit. In Fig. 1, reference character 1 designates a heat radiating unit; and, 4a and 4b stand for the side surface portion and the top surface portion of the heat radiating unit 1 respectively, while they form the outer peripheral portion of the heat radiating unit 1. Also, 28 designates the power transistor in the primary side inverter circuit shown in the circuit diagram of Fig. 5. Further, 10a stands for an opening formed in the end portion of the heat radiating unit 1, and 8 designates fans respectively arranged in the opening 8. The respective surfaces of the side surface portion 4a and top surface portion 4b are formed in such a manner that the power transistor 28 and the like are connected to flat plates such as thin metal plates which are the base materials of the portions 4a and 4b; and, owing to the thus formed surfaces, the heat radiating unit 1 has a tunnel structure including a cavity portion. That is, the heat radiating unit 1 has a tunnel structure in which the electrical element generating intense heat is used as part of the outer peripheral portion thereof defined by the top surface portion and side surface portion thereof, the cavity portion 3 is defined by the outer peripheral portion; and, the heat is discharged in such a manner that the cavity portion and the outside are isolated from each other.

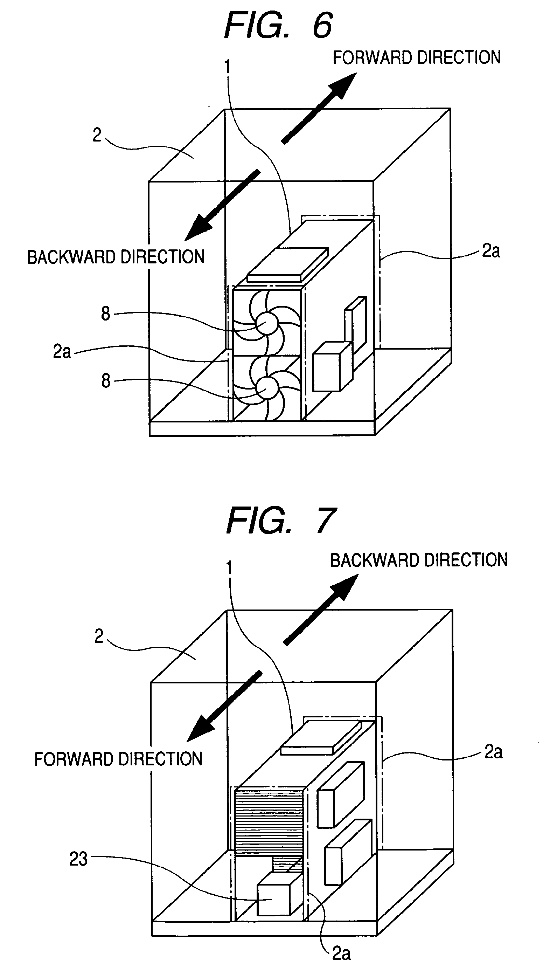

By the way, the heat radiating unit 1, as shown in Fig. 6, is built into the box body 2 to thereby provide a welding control unit and, in the present embodiment, the heat radiating unit 1 is disposed in such a manner that the portion thereof including the fan 8 provides the rear surface portion of the welding control unit.

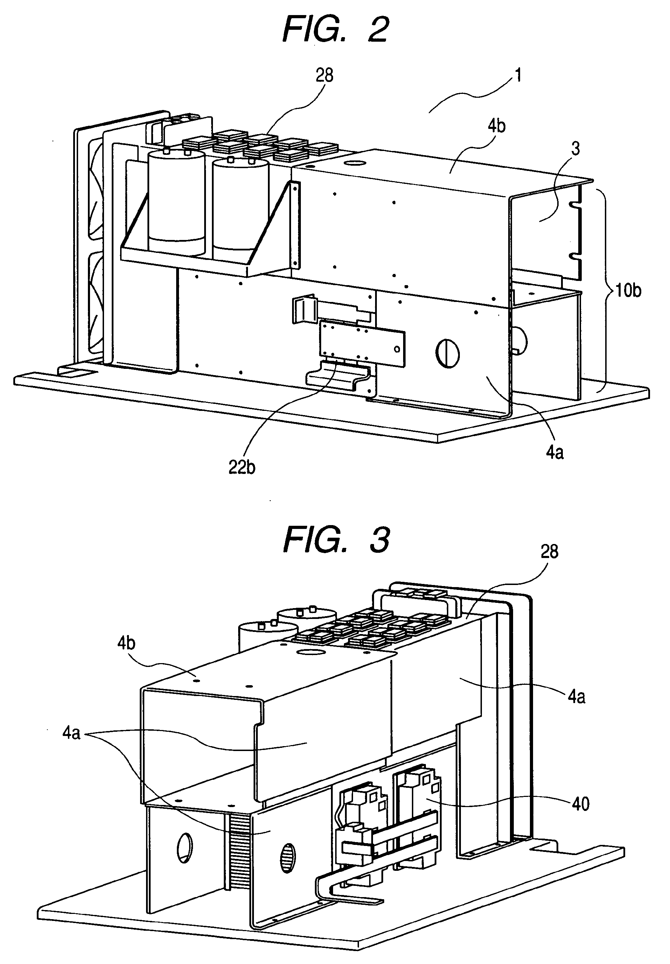

Also, Fig. 2 is a perspective view of the same heat radiating unit 1 used in the arc welding control unit according to the present embodiment as shown in Fig. 1, when viewed from the forward and leftward direction thereof In Fig. 2, reference character 10b designates an opening formed on the opposite side to the fan 8 of the two side end portions of the heat radiating unit 1, while 3 stands for a cavity portion which is defined by the side surface portion 4a and top surface portion 4b of the heat radiating unit 1. That is, the heat radiating unit 1 has a tunnel structure including a cavity portion defined by the side surface portion 4a and top surface portion 4b and includes two openings respectively formed in the two end portions thereof, with a fan provided on one of the two openings.

Also, Fig. 3, similarly to the above figures, is a perspective view of the heat radiating unit 1, when viewed from the forward and rightward direction thereof In Fig. 3, 40 designates a switching element which, although not shown in the circuit diagram of Fig. 5, is used in a secondary side circuit and gives off intense heat.

And, Fig. 4, similarly to Fig. 3, is a perspective view of the heat radiating unit 1, when viewed from the forward and rightward direction thereof, and, for easy understanding of the inside thereof, it is shown in such a manner that the middle portion thereof is cut. In Fig. 4, 6 designates heat sinks and 7 stands for heat radiating fins. The heat sinks 6 are respectively included in the respective electrical elements of the power transistor 28, secondary side switching element 40 and secondary side rectify diode 22; and, the portions thereof including the heat radiating fins 7 are exposed to the inside of the heat radiating unit 1 having a tunnel structure, that is, to the portion of the cavity portion 3 through which the air is allowed to flow. Also, the heat radiating unit 1 has cavity portions respectively in the two upper and lower stage structure; in each stage structure, there are provided two or more rows of cavities separated from one another with partitions between them; and, the respective cavity portions 3 are formed to allow the air to flow therethrough.

As described above, the heat radiating unit 1 according to the present embodiment, as shown in Fig. 1, has a substantially cuboid shape, in which the fan 8 is arranged in the opening 10a formed in the front surface thereof and is used as an air intake opening, whereas the air is exhausted from the opposite opening 10b. In this case, on the heat radiating unit 1, there is mounted, of the electrical elements constituting the circuits of the present welding control unit, the electrical element that gives off specially intense heat; and, the heat radiating fin portions of the heat sinks 6 are exposed to the cavity portions 3 through which the air flows, whereby the heat can be discharged out of the control unit with high efficiency.

By the way, in this case, as shown in Fig. 4, in the heat sinks 8, the two or more heat radiating fins 7 should be disposed to be substantially parallel with the direction of flow of the air flowing through the cavities 3, thereby being able to prevent the flow of the air from stagnating.

Also, according to the present embodiment, since the heat radiating unit 1 has a two-stage (upper-and-lower-stage) structure, for example, the electrical elements giving off intense heat can be cooled in the cavity portions exclusively arranged for cooling purpose, thereby preventing them from interfering with the promotion of the cooling of the remaining electrical elements.

In this manner, the side surface portion 4a and top surface portion 4b defining the outer peripheral surface of the heat radiating unit 1 are respectively formed as flat surfaces capable of shutting off the air, the flow of the air between the cavity portions 3 defined by these flat surfaces and the outside is cut off. Further dust, welding fumes and the like can be prevented from entering the conductive portions of the interior portions of the tunnel structure of the heat radiating unit 1.

And, as shown in Fig. 6, the heat radiating unit 1 is built into the box body 2 to thereby provide an arc welding control unit. At the then time, the box body 2 is arranged such that it includes two air flow holes 2a previously formed in the mutually facing surfaces thereof respectively, so that the openings 10a and 10b of the heat radiating unit 1 can be respectively engaged with the air flow holes 2a. That is, the heat radiating unit 1 is disposed such that the openings 10a and 10b of the two side end portions thereof respectively face the inside surfaces of the mutually facing surfaces of the box body 2. And, the fans 8 provided in the heat radiating unit 1 are arranged to face the inside surface of the rear surface of the arc welding control unit, the air is sucked in from the outside, and heat is discharged to the outside from the air flow hole 2a formed in the front surface of the control unit. And, as described above, in the inside of the box body 2, due to the tunnel structure of the heat radiating unit 1, heat transmission can be cut off between the cavity portions of the interior portion of the unit 1 and the outside, thereby being able to cool the electrical elements efficiently.

By the way, in the present embodiment, the fans 8 are mounted on the heat radiating unit 1. However, according to the conveniences of design of the control unit, they may also be mounted in the air flow holes 2a of the box body 2 or may be interposed between the inside surface of the box body 2 and the opening 10a of the heat radiating unit 1. Each of them has no ill influence on the effect of the present embodiment.

Also, although the heat radiating unit 1 is formed to have a two upper and lower stage structure, the structure is not limited to the two-stage structure, but two or more lines or rows of cavity portions may also be provided in the horizontal and/or vertical direction, which makes it possible to discharge heat with more efficiency. Also, for design's convenience, the cavity portions may be used respectively to discharge the heat of different electrical elements, or one of more cavity portions may be used to discharge the heat of two or more electrical elements.

Further, the shape of the heat radiating unit 1 is not limited to a substantially cuboid shape but it may be other shape such as a cylindrical shape, provided that it is capable of forming a tunnel structure.

As described above, according to the present embodiment, since the heat sink 8 and box body 9 are shut off from the air existing in the inside of the equipment, dust, welding fumes and the like can be prevented from accumulating on or adhering to the conductive portions of the inside of the equipment. This not only can improve the maintenance of the equipment greatly but also can secure the reliability of the equipment as well.

In addition, as shown in Fig. 7 illustrating a developed example of the present embodiment, in the inside of the heat radiating unit 1 having a tunnel structure, there may be provided the dc reactor 23 shown in Fig. 5. In this case, when the dc reactor 23, which is one of heat generating sources, is arranged in the lower-stage cavity portion of the heat radiating unit 1 having a two stage structure and is exposed to a different row of cavity portions from those in the upper stage, the cavity portions in the lower stage can be shut off from the remaining rows of cavity portions, thereby being able to cool the electrical elements with high efficiency.

By the way, the dc reactor for an arc welding control unit is impregnated with varnish, which raises no problem relating to the accumulation of dust and the like.

As described above, according to the present embodiment, since the heat sinks 7 and heat radiating unit 1 are shut off from the air existing in the inside of the welding control unit, dust, welding fumes and the like can be prevented from accumulating on and adhering to the conductive portions of the inside of the equipment. Thanks to this, the maintenance of the equipment can be improved greatly and the reliability of the equipment can also be secured.

By the way, in place of the dc reactor 23 shown in Fig. 7, there may also be used the main transformer 21 shown in Fig. 5.

### INDUSTRIAL PRACTICABILITY

An arc welding control unit according to the invention can prevent dust, welding fumes and the like from accumulating on or adhering to the conductive portions of the equipment to thereby be able not only to improve the maintenance of the equipment greatly but also to secure the reliability of the equipment as well. Therefore, the present arc welding control unit is industrially useful. Also, the invention not only can be usefully applied to an arc welding control unit but also can be usefully applied to a wide range of apparatus which have built-in electrical elements generating intense heat and require cooling them.

### BRIEF DESCRIPTION OF THE DRAWINGS

Fig. 1 is a perspective view of a heat radiating unit used in an arc welding control unit according to an embodiment 1 of the invention, when viewed from the backward and rightward direction thereof.
Fig. 2 is a perspective view of a heat radiating unit used in an arc welding control unit according to the embodiment 1 of the invention, when viewed from the forward and leftward direction thereof
Fig. 3 is a perspective view of a heat radiating unit used in an arc welding control unit according to the embodiment 1 of the invention, when viewed from the backward and rightward direction thereof.
Fig. 4 is a perspective view of a heat radiating unit used in an arc welding control unit according to the embodiment 1 of the invention, when viewed from the backward and rightward direction thereof
Fig. 5 is a circuit diagram of the circuit configurations of an arc welding control unit according to the embodiment 1 of the invention.
Fig. 6 is a perspective view of an arc welding control unit according to the embodiment 1 of the invention, when viewed from the backward and rightward direction thereof.
Fig. 7 is a perspective view of an arc welding control unit according to the embodiment 1 of the invention, when viewed from the forward and rightward direction thereof.
Fig. 8 is a perspective view of a conventional arc welding control unit, when viewed from the backward and rightward direction thereof.

### DESCRIPTION OF REFERENCE CHARACTERS

- 1:: Heat radiating unit
- 2:: Box body
- 2a:: Air flow hole
- 3:: Cavity portion
- 4a:: Side surface portion
- 4b:: Top surface portion
- 6:: Heat sink
- 7:: Heat radiating fin
- 8:: Fan
- 10a, 10b:: Opening
- 22:: Secondary side rectify diode
- 28:: Power transistor
- 21:: Main transformer
- 22:: Secondary side rectify diode
- 23:: DC reactor
- 26:: Primary side rectify diode
- 27:: Primary smoothing capacitor
- 28:: Transformer
- Fig. 6: Forward direction Backward direction
- Fig. 7: Backward direction Forward direction

## Claims

1. An arc welding control unit comprising a heat radiating unit built in a box body for discharging the air heated by a heat generating first electrical element to the outside, wherein the heat radiating unit has a tunnel-type shape including an outer peripheral portion for defining a cavity portion allowing the air to flow therethrough.

2. An arc welding control unit as set forth in Claim 1, wherein the heat radiating unit has a substantially cuboid shape including a side surface portion and a top surface portion for defining the cavity portion.

3. An arc welding control unit as set forth in Claim 1 or 2, wherein the heat radiating unit has two openings respectively formed in the two side end portions of the cavity portion allowing the air to flow therethrough.

4. An arc welding control unit as set forth in Claim 3, wherein the heat radiating unit is disposed such that the two openings formed in the two side end portions thereof respectively face the inside surface of the box body.

5. An arc welding control unit as set forth in any one of Claims 1 to 4, wherein the heat radiating unit uses the heat generating first electrical element in at least part of the outer peripheral portion defining the cavity portion.

6. An arc welding control unit as set forth in Claim 5, wherein the heat generating first electrical element includes a heat sink having a heat radiating fin, and the heat radiating fin is exposed to the inside of the cavity portion through which the air flows.

7. An arc welding control unit as set forth in any one of Claims 3 to 6, wherein, in one of the two openings, there is provided a fan for forcing the air existing in the cavity portion to flow through the cavity portion.

8. An arc welding control unit as set forth in Claim 7, wherein the fan is mounted on the opening of the heat radiating unit.

9. An arc welding control unit as set forth in Claim 7, wherein the fan is mounted on an air flow hole portion formed in the box body for allowing the air to flow therethrough.

10. An arc welding control unit as set forth in any one of Claims 1 to 9, wherein the heat radiating unit includes two or more first electrical elements in the outer peripheral portion thereof defining the cavity portion.

11. An arc welding control unit as set forth in any one of Claims 1 to 10, wherein the heat radiating unit include two or more rows of cavity portions.

12. An arc welding control unit as set forth in Claim 11, wherein the heat radiating unit includes fans respectively disposed in every cavity portions formed in two or more rows.

13. An arc welding control unit as set forth in Claim 11 or 12, wherein the heat radiating unit allows the air of different first electrical elements in every cavity portions to flow.

14. An arc welding control unit as set forth in any one of Claims 1 to 13, wherein the first electrical element includes an electrical element used in an inverter circuit arranged in the arc welding control unit.

15. An arc welding control unit as set forth in Claim 14, wherein the first electrical element includes a power transistor.

16. An arc welding control unit as set forth in any one of Claims 1 to 15, wherein the first electrical element includes a rectify diode.

17. An arc welding control unit as set forth in any one of Claims 1 to 16, wherein, in the cavity portion, there is disposed a heat generating second electrical element.

18. An arc welding control unit as set forth in Claim 17, wherein the second electrical element includes a reactor.

19. An arc welding control unit as set forth in Claim 17 or 18, wherein the second electrical element includes a transformer.
